# EUROPÄISCHE PATENTSCHRIFT

(11) **EP 0 269 126 B1**
(45) Veröffentlichungstag und Bekanntmachung des Hinweises auf die Patenterteilung: **03.02.1993**
(21) Anmeldenummer: 87117612.9
(22) Anmeldetag: 27.11.1987
(51) Int. Cl.: H05K 9/00

(54) **Abgeschirmtes Gehäuse**
Screened case
Boîtier blindé

(30) Priorität: 28.11.1986 DE 3640817
(43) Veröffentlichungstag der Anmeldung: 01.06.1988
(73) Patentinhaber: ZEPPELIN-Metallwerke GmbH, D-88015 Friedrichshafen (DE)
(72) Erfinder: Bergerhoff, Jürgen, Dipl.-Ing, (DE)
(74) Vertreter: Tiedtke, Harro, Dipl.-Ing.

(56) Entgegenhaltungen:
- EP-A- 0 095 743
- EP-A- 0 159 407
- EP-A- 0 200 054
- GB-A- 2 151 461

## Beschreibung

Die Erfindung betrifft ein Gehäuse, das gegenüber elektrischen und/oder magnetischen Feldern abgeschirmt ist, mit zumindest einer Öffnung und einer zugehörigen Abdeckung, wobei die Öffnung und die Abdeckung an ihren Rändern von einem Profil bzw. einem Gegenprofil eingefaßt sind, die in geschlossenem Zustand umlaufend über federnde Kontakte elektrisch leitend miteinander verbunden sind.

Derartige Gehäuse dienen beispielsweise zur Unterbringung von Geräten oder Anlagen, die gegenüber elektischen und/oder magnetischen Feldern abgeschirmt werden müssen. In Betracht kommen Gehäuse durchaus unterschiedlicher Größe, sei es, daß diese beispielsweise tragbar sind oder es sich um sog. Shelter handelt, die von Fahrzeugen transportiert werden können. Diese Gehäuse können auch im Bereich der Datenverarbeitung oder der medizinischen Technik verwandt werden.

Es ist ein Gehäuse bekannt, und zwar ein Shelter in Quaderform, der aus fugenlosen Sandwich-Platten besteht.

Diese Platten sind dreischichtig aufgebaut und weisen als Deckschichten eine Außen- und Innenbeplankung auf. Zwischen diesen Beplankungen befindet sich ein Stützkern aus Hartschaum, der mit den Deckschichten im Vakuum-Klebeverfahren verklebt ist. Sowohl die Außen- als auch die Innenbeplankung ist elektrisch leitend und kann aus einem Metall, wie Stahl oder Aluminium, bestehen.

Ein solcher Shelter weist als Öffnung und zugehörige Abdeckung eine Tür auf Sowohl die Türöffnung als auch der Türrand sind von einem Profil bzw. einem Gegenprofil eingefaßt. Diese Profile sind in geschlossenem Zustand über ihren gesamten Verlauf durch federnde Kontakte elektrisch leitend miteinander verbunden.

Es handelt sich dabei um eine umlaufende Reihe von Einzelkontakten. Diese sind mit einer Anlagefläche der Öffnung elektrisch leitend verbunden, während eine zugeordnete Anlagefläche der Tür die elektrische Leitung durch federnde Verformung der Kontakte herstellt. Dies hat zur Folge, daß die Kontakte in Schließrichtung verformt werden, so daß beim Schließen eine zunehmende Federkraft überwunden werden muß. Nach Erreichen der Schließstellung liegt eine verhältnismäßig große Federkraft umlaufend an dem Gegenprofil an. Dies kann dazu führen, daß sich die Tür verzieht und die elektrisch leitende Verbindung mit der Öffnung nicht mehr gewährleistet ist. Dadurch wird die Abschirmung in erheblichem Maße beeinträchtigt.

An dem bekannten Gehäuse hat sich weiterhin als Nachteil erwiesen, daß die federnden Kontakte an ungeschützter Stelle mit dem Profil verbunden sind. Wenn nämlich die Kontakte lediglich an einer Anlagefläche angebracht sind, besteht die Gefahr, daß dort Beschädigungen eintreten, sei es aus Versehen oder gedankenlosem Manipulieren an den Kontakten. Vor allem aber sind die Kontakte der Gefahr einer Beschädigung oder sogar Zerstörung ausgesetzt, wenn Bedienungspersonal beim Betreten des Gehäuses versehentlich mit dem Schuhwerk an die Kontakte stößt.

Aus der EP-A-0 200 054 ist ein Gehäuse bekannt, das über ein mehrteiliges Profilsystem verfügt und geschützte Kontakte aufweist. Hierzu ist ein Profil mit einem U-förmigen Kontaktbereich vorgesehen, in den das Kontaktelement des gegenüberliegenden Profils eingreift. Der Ü-förmige Bereich wird dabei durch zwei Profilstücke gebildet, die miteinander und mit dem Rahmen des Gehäuses verschweißt werden. Dieses System hat jedoch den Nachteil, daß es aufwendig zu montieren ist und darüberhinaus nicht mehr demontiert werden kann. Außerdem müssen bei diesem System die Kontakte im U-förmigen Bereich von der Öffnung des U-förmigen Bereichs her montiert werden, da diese sonst nicht mehr ausgewechselt werden können. Eine sichere Befestigung der Kontakte von dieser Seite her ist jedoch aufwendig, da das Kontaktelement beim Lösen des Eingriffs immer die Tendenz hat, die Kontakte mitherauszuziehen.

Dem Anmeldungsgegenstand liegt die Aufgabe zugrunde, ein Profilsystem zu schaffen, das einfach montiert und demontiert werden kann und eine sichere sowie einfache Befestigung der Kontakte im U-förmigen Kontaktbereich ermöglicht.

Die Aufgabe wird anmeldungsgemäß durch die Merkmale des neuen Hauptanspruchs gelöst; durch die Teilung der Profilleisten in Innen- und Außenleiste, die erst im Zusammenspiel den U-förmigen Kontaktbereich ergeben, wird ein einfach zu montierendes demontierbares Profilsystem geschaffen, dessen Kontakte im U-förmigen Kontaktbereich einfach und sicher befestigt werden können, beispielsweise durch Anschrauben, da der U-förmige Bereich jederzeit durch Demontage eines Profils wieder geöffnet werden kann.

Darüberhinaus gestattet diese Gestaltung den Aufbau eines Baukastensystems, bei dem für verschiedene Gehäusewandstärken beispielsweise immer das gleiche Außenprofil mit unterschiedlichen Innenprofilen verwendet werden kann.

Im einzelnen ist vorgesehen, daß das Profil in ein Randprofil und ein Innenprofil geteilt ist, die miteinander verbunden sind, wobei das Randprofil an seiner Außenseite den Rand des Profils und an seiner Innenseite den einen Schenkel der U-förmigen Rille bildet, während das Innenprofil den anderen Schenkel der U-förmigen Rille bildet.

Eine günstige Herstellung und Montage von Rand- und Innenprofil wird dadurch erreicht, daß das Innenprofil auch den wesentlichen Teil des Steges der U-förmigen Rille bildet und über einen randparallelen Verbindungssteg mit dem Randprofil vorzugsweise etwa in der Mitte des Randes verbunden, beispielsweise verschraubt ist. Die Verschraubung kann dann von der Außenseite her erfolgen. Eine lösbare Verbindung von Rand- und Innenprofil, wie eine Verschraubung, bietet die Möglichkeit, daß ein zunächst nicht abgeschirmtes Gehäuse nachgerüstet werden kann, indem Rand- und Innenprofil zunächst für die Nachrüstung mühelos demontiert und anschließend wieder montiert werden. Hierfür liegt zweckmäßig das Ende des randparallelen Verbindungssteges an einem im Randprofil ausgebildeten Anschlag an. Demontage und Montage erweisen sich als besonders einfach, wenn die Profile an ihren Gehrungen verlötet oder verschweißt und dadurch rundum einstückig sind.

Eine Abschirmung kann bereits dadurch erreicht werden, daß die Kontakte lediglich an einem Schenkel der U-förmigen Rille angeordnet sind. Die Abschirmung wird jedoch wesentlich dadurch verbessert, daß an beiden Schenkeln Kontakte vorgesehen sind. Dann liegen in der Schließstellung an dem Kontaktsteg beidseits etwa gleichgroße Federkräfte an, die sich also im wesentlichen aufheben.

Nach einer bevorzugten Ausgestaltung der Erfindung sind weitere Kontakte in einer U-förmigen, in Schließrichtung offenen Gegenrille des Gegenprofils angeordnet, während das Profil, insbesondere Randprofil, im Bereich der Gegenrille mit einem in Schließrichtung angeordneten Kontaktschuh versehen ist. Je nachdem, ob an einem oder beiden der Schenkel der U-förmigen Rille Kontakte angeordnet sind, stellen die Kontakte in der U-förmigen Gegenrille die zweite oder dritte Kontaktreihe dar. Durch die dritte Kontaktreihe wird eine gegenüber bekannten Abschirmungen entscheidend größere Dämpfung erreicht. Der Verlauf der Dämpfung über den einschlägigen Frequenzbereich entspricht den bei sehr großen elektrischen und/oder magnetischen Feldern geforderten Werten.

Gemäß dieser Ausgestaltung der Erfindung sind auch hier die Kontakte geschützt untergebracht, nämlich in der U-förmigen Gegenrille. Der Kontaktschuh eignet sich für eine sichere elektrische Leitung.

In weiterer Ausgestaltung der Erfindung fluchtet der Steg der Gegenrille mit einer Seite des Gegenprofils, während der eine Schenkel von dem Rand des Gegenprofils und der andere Schenkel von dem Kontaktsteg gebildet wird, wobei die Kontakte an dem Steg angeordnet sind. Hierdurch wird eine gedrängte Anordnung von Profil und Gegenprofil erreicht. Außerdem entsteht so zwischen Profil und Gegenprofil ein Labyrinth, das die Abschirmung besonders effektiv werden läßt. Gleichzeitig ist eine lückenlose elektrische Leitung durch zwei oder drei umlaufende Kontaktreihen gegeben. Die Montage der Kontakte in der Gegenrille bereitet keine Schwierigkeiten, da diese auf dem Steg angeordnet werden können.

Die Erfindung kann außerdem so ausgestaltet werden, daß das Gegenprofil mit einem im wesentlichen in Schließrichtung angeordneten Dichtsteg versehen ist, der in eine im Profil angeordnete elastische Dichtung eingreift. Diese elastische Dichtung dient dazu, die Fuge zwischen Profil und Gegenprofil insbesondere vor Witterungseinflüssen zu schützen. Gleichzeitig erfüllt der Dichtsteg die Aufgabe, die Abschirmung zu vergrößern, indem der Dichtsteg Bestandteil des Labyrinths ist.

Dies wird in Ausgestaltung der Erfindung zweckmäßig dadurch erreicht, daß der Dichtsteg an einer Verlängerung des Steges der Gegenrille ausgebildet ist, während der durch das Innenprofil gebildete Schenkel der U-förmigen Rille in den Bereich zwischen Kontaktsteg und Dichtsteg eingreift. Daraus geht anschaulich der ausgedehnte Verlauf des Labyrinths hervor.

Die elastische Dichtung kann in einer Ausnehmung des Profils angeordnet sein, während die Außenseite der Dichtung mit der Seite des Profils fluchtet. Durch diese Maßnahmen wird erreicht, daß die Dichtung, von außen betrachtet, am Beginn des Labyrinths angeordnet ist. So wird von vornherein verhindert, daß Witterungseinflüsse auf die für die Abschirmung vorgesehenen Elemente einwirken. Die Gefahr von Korrosion wird dadurch entscheidend vermindert. Hierzu trägt bei, daß Profil und Gegenprofil gemäß der Erfindung aus Messing bestehen.

Eine zusätzliche Maßnahme für den Schutz gegenüber Feuchtigkeit besteht darin, daß die Außenseite des Dichtsteges mit der Seite des Gegenprofils einen stumpfen Winkel einschließt. Die Dichtwirkung kann noch dadurch erhöht werden, daß das Ende des Dichtsteges verhältnismäßig spitz ausgestaltet ist, damit ein hoher Dichtdruck aufgebracht werden kann und außerdem genügend Toleranz für die Schließstellung gegeben ist.

Nicht nur das Profil sondern auch das Gegenprofil kann gemäß der Erfindung geteilt und über randparallele Verbindungsstege vorzugsweise etwa in der Mitte des Randes verbunden, beispielsweise verschraubt sein, wobei das Ende eines Verbindungssteges an einem am anderen Verbindungssteg ausgebildeten Anschlag anliegt. Aus dieser Maßnahme folgt sowohl für das Profil als auch das Gegenprofil, daß bei der Montage einerseits das Randprofil und andererseits das Innenprofil jeweils auf die Außen- bzw. Innenbeplankung aufgelegt werden können. Dann werden die einerseits zwischen Außenbeplankung und Randprofil, andererseits zwischen Innenbeplankung und Innenprofil anzuordnenden Kontaktgewebe od. dgl. in den dafür vorgesehenen Ausnehmungen innerhalb des Rand- bzw. Innenprofils lediglich eingezwängt, ohne daß deren Lage also verändert wird.

Demgegenüber müssen bekannte einstückige Profile mit in den Ausnehmungen angeordneten Kontaktgeweben od. dgl. auf die Platten aufgeschoben werden. Während des Aufschiebens bewegen sich die Kontaktgewebe od. dgl. aber allzu leicht aus ihrer Lage in den Ausnehmungen, um irgendeine nicht gewünschte Lage einzunehmen. Dann erfüllen aber die Kontaktgewebe od. dgl. nicht mehr ihre Aufgabe, die elektrische Leitung zwischen Profil und der Außen- sowie Innenbeplankung zu gewährleisten.

Weitere Merkmale und Vorteile der Erfindung ergeben sich aus der folgenden Beschreibung eines, die Erfindung nicht beschränkenden Ausführungsbeispieles, wobei auf die Zeichnung Bezug genommen wird. Es zeigen:
- Fig. 1: Drehflügeltür und Türgewände eines Shelters an der Verschlußseite der Tür im Teilquerschnitt,
- Fig. 2: Innenprofil und Randprofil vor der Montage des Randprofiles im Querschnitt,
- Fig. 3: Innenprofil und Randprofil während der Montage des Randprofiles im Querschnitt und
- Fig. 4: Innenprofil und Randprofil nach der Montage des Randprofiles im Querschnitt.

Sowohl das Türgewände 11 des nicht weiter dargestellten Shelters als auch die Tür 12 bestehen aus fugenlosen Sandwich-Platten, die dreischichtig aufgebaut sind.

Dabei besteht sowohl die Außenbeplankung 13 als auch die Innenbeplankung 14 aus Aluminiumblech. Zwischen diesen Beplankungen befindet sich ein Hartschaum-Stützkern 15 aus Polyurethan.

Sowohl das Türgewände 11 als auch die Tür 12 sind von einem Profil bzw. einem Gegenprofil aus Messing eingefaßt. Diese Profile sind in geschlossenem Zustand umlaufend durch federnde Kontakte 16, 17 und 18 elektrisch leitend miteinander verbunden. Die Kontakte 16 und 17 sind in einer U-förmigen, in Schließrichtung offenen Rille des Profils angeordnet, während das Gegenprofil im Bereich der Rille mit einem in Schließrichtung angeordneten Kontaktsteg 19 versehen ist.

Das Profil ist in der U-förmigen Rille im Bereich des Steges in ein Randprofil 20 und ein Innerprofil 21 geteilt. Diese sind bei 22 durch eine nicht dargestellte Verschraubung miteinander verbunden. Das Randprofil 20 bildet an seiner Außenseite den Rand 23 des Profils und an seiner Innenseite den einen Schenkel der U-förmigen Rille. Dagegen bildet das Innenprofil 21 den anderen Schenkel der U-förmigen Rille. Außerdem bildet das Innenprofil 21 den wesentlichen Teil des Steges der U-förmigen Rille.

Das Innenprofil 21 ist über einen Randparallelen Verbindungssteg 24 etwa in der Mitte des Randes 23 mit dem Randprofil 20 bei 22 verschraubt. Dabei liegt das Ende des randparallelen Verbindungssteges 24 an einem im Randprofil 20 ausgebildeten Anschlag 25 an.

Während die Kontakte 16 und 17 an den beiden Schenkeln der U-förmigen Rille angeordnet sind, befinden sich die weiteren Kontakte 18 in einer U-förmigen, in Schließrichtung offenen Gegenrille des Gegenprofils 26, 27. Dabei ist das Randprofil 20 im Bereich der Gegenrille mit einem in Schließrichtung angeordneten Kontaktschuh 28 versehen. Der Steg der Gegenrille fluchtet mit einer Seite des Gegenprofils 27, während der eine Schenkel von dem Rand 29 des Gegenprofils 27 und der andere Schenkel von dem Kontaktsteg 19 gebildet wird, wobei die Kontakte 18 an dem Steg angeordnet sind.

Das Gegenprofil 27 ist mit einem im wesentlichen in Schließrichtung angeordneten Dichtsteg 30 versehen, der in eine im Innenprofil 21 angeordnete elastische Dichtung 31 eingreift. Dabei ist der Dichtsteg 30 an einer Verlängerung 32 des Steges der Gegenrille 27 ausgebildet, während der durch das Innenprofil 21 gebildete Schenkel der U-förmigen Rille in den Bereich zwischen Kontaktsteg 19 und Dichtsteg 30 eingreift.

Die elastische Dichtung 31 ist in einer Ausnehmung des Innenprofils 21 angeordnet, während die Außenseite der Dichtung 31 mit der Seite des Innenprofils 21 fluchtet. Dabei schließt die Außenseite des Dichtsteges 30 mit der Seite des Gegenprofils 27 einen stumpfen Winkel ein.

Auch das Gegenprofil 26, 27 ist geteilt und über randparallele Verbindungsstege 33 und 34 etwa in der Mitte des Randes verschraubt. Dabei liegt das Ende des Verbindungssteges 34 an einem am anderen Verbindungssteg 33 ausgebildeten Anschlag 35 an.

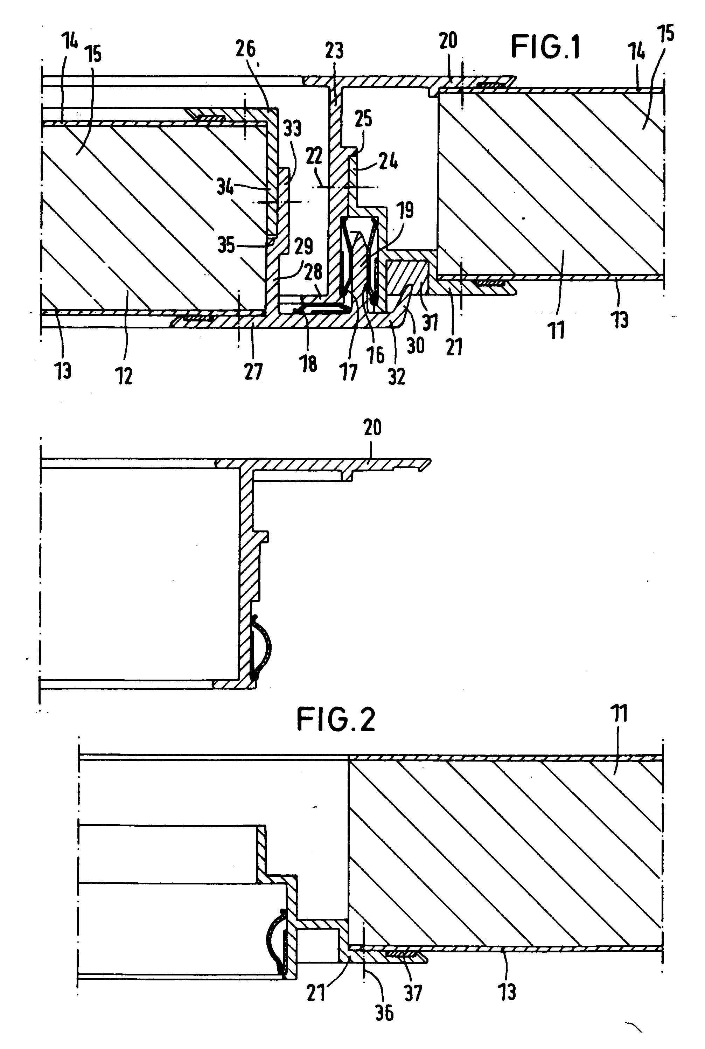

Die Fig. 2, 3 und 4 zeigen Schritte der Montage von Randprofil 20 und Innenprofil 21. Das Innenprofil 21 ist bereits bei 36 mit dem Türgewände 11 verbunden, beispielsweise vernietet. Dazu ist das Innenprofil 21 auf die Außenbeplankung 13 aufgelegt worden. Zuvor ist ein Kontaktgewebe 37 in eineAusnehmung des Innenprofils 21 eingelegt und mit der Vernietung dort eingezwängt worden. Dabei hat sich die Lage des Kontaktgeweges 37 nicht verändert, da das Innenprofil 21 gegenüber dem Türgewände nicht verschoben werden mußte, vielmehr lediglich ein Auflegen erforderlich war.

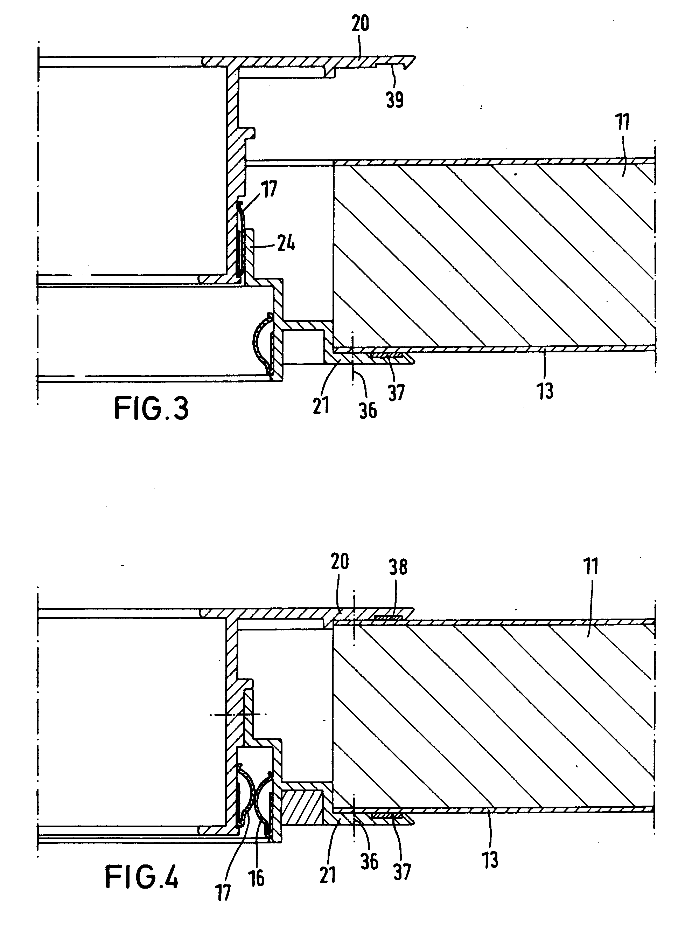

Fig. 3 zeigt den Augenblick der Montage, in dem der Verbindungssteg 24 des Innenprofils 21 über die Kontaktfeder 17 geschoben wird und diese dabei federnd verformt. Fig. 4 zeigt dann den montierten Zustand, bei dem die Kontaktfeder 17 in die Kontaktlage zu der Kontaktfeder 16 zurückgefedert ist. Inzwischen war in eine Ausnehmung 39 des Randprofils 20 ein weiteres Kontaktgewebe 38 eingelegt worden, das in Fig. 4 seine eingezwängte Lage erhalten hat.

Weitere Ausgestaltungen der Erfindung sind möglich, ohne daß dabei der Erfindungsgedanke verlassen wird. So kann das Profil an der Tür und das Gegenprofil am Türgewände angeordnet werden.

## Patentansprüche

1. Profilsystem zur elektrisch/magnetischen Abschirmung eines Gehäuses, das eine mit einer Abdeckung verschließbare Öffnung hat, mit mehrteiligen Profilleisten (20,21,26,27), die mit dem Randbereich der Öffnung und der Abdeckung verbindbar sind und über federnde Kontakte (16,17,18) verfügen, wobei ein Kontaktsteg (19) einer Profilleiste (26,27) in einen U-förmigen Kontaktbereich einer anderen Profilleiste (20,21) eingreift **dadurch gekennzeichnet, daß** die Profilleisten (20,21,26,27) in getrennt montierbare Innen- (21,27) und Außenleisten (20,26) geteilt sind, die lösbar miteinander verbindbar sind, wobei der U-förmige Kontaktbereich durch das Zusammenwirken von Innen- (21) und Außenleiste (20) gebildet wird.

2. Profilsystem nach Anspruch 1, **dadurch gekennzeichnet, daß** die Profilleiste (20,21) im U-förmigen Kontaktbereich im Bereich des Kontaktsteges (19) geteilt ist.

3. Profilsystem nach Anspruch 1 oder 2, dadurch gekennzeichnet, daß das die Außenleiste (20) an ihre Außenseite einen Rand (23) und an ihrer Innenseite einen Schenkel des U-förmigen Kompaktbereichs bildet, während die Innenleiste (21) den anderen Schenkel des U-förmigen Kontaktbereichs bildet.

4. Profilsystem nach Anspruch 3, dadurch gekennzeichnet, daß die Innenleiste (21) auch den wesentlichen Teil des Steges des U-förmigen Kontaktbereichs bildet und über einen randparallelen Verbindungssteg 24 mit der Außenleiste 20 vorzugsweise etwa in der Mitte des Randes verbunden 22 ist.

5. Profilsystem nach Anspruch 4, dadurch gekennzeichnet, daß das Ende des randparallelen Verbindungssteges (24) an einem in der Außenleiste (20) ausgebildeten Anschlag (25) anliegt.

6. Profilsystem nach einem der Ansprüche 1 bis 5, dadurch gekennzeichnet, daß die federnden Kontake (16, 17) an zumindest einem Schenkel des U-förmigen Kontaktbereichs angeordnet sind.

7. Profilsystem nach einem der Ansprüche 1 bis 6, dadurch gekennzeichnet, daß weitere Kontakte (18) in einer U-förmigen in Schließrichtung offenen Gegenrille der Profilleiste (26, 27) angeordnet sind, während das Profil, insbesondere die Außenleiste (20) im Bereich der Gegenrille mit einem in Schließrichtung angeordneten Kontaktschuh (28) versehen ist.

8. Profilsystem nach Anspruch 7, dadurch gekennzeichnet, daß der Steg der Gegenrille mit einer Seite der Profilleiste (26, 27) fluchtet, während der eine Schenkel von dem Rand 29 der Profilleiste 26, 27 und der andere Schenkel von dem Kontaktsteg 19 gebildet wird, wobei die Kontakte 18 an dem Steg angeordnet sind.

9. Profilsystem nach einem der Ansprüche 1 bis 8, dadurch gekennzeichnet, daß die Profilleiste (26, 27) mit einem im wesentlichen in Schließrichtung angeordneten Dichtsteg (30) versehen ist, der in eine in der Profilleiste (20, 21) angeordnete elastische Dichtung (31) eingreift.

10. Profilsystem nach Anspruch 9, dadurch gekennzeichnet, daß der Dichtsteg (30) an einer Verlängerung (32) des Steges der Gegenrille ausgebildet ist, während der durch die Innenleiste (21) gebildete Schenkel des U-förmigen Kontaktbereichs in den Bereich zwischen Kontaktstück (90) und dem Dichtsteg (30) eingreift.

11. Profilsystem nach Anspruch 9 oder 10, dadurch gekennzeichnet, daß die elastische Dichtung (31) in einer Ausnehmung der Profilleiste (20, 21) angeordnet ist, während die Außenseite der Dichtung (31) mit der Seite der Profilleiste (20, 21) fluchtet.

12. Profilsystem nach einem der Ansprüche 9 bis 11, dadurch gekennzeichnet, daß die Außenseite des Dichtstegs 30 mit der Seite der Profilleiste (26, 27) einen stumpfen Winkel einschließt.

13. Profilsystem nach einem der Ansprüche 1 bis 12, dadurch gekennzeichnet, daß die Profilleiste (26, 27) über randparallele Verbindungsstege (33, 34) vorzugsweise etwa in der Mitte des Randes verbunden, verschraubt ist, wobei das Ende eines Verbindungssteges (34) an einem anderen Verbindungssteg (33) ausgebildeten Anschluß (35) anliegt.

14. Profilsystem nach einem der Ansprüche 1 bis 13, dadurch gekennzeichnet, daß die Kontaktfedern (16, 17) in einem Rücksprung der Profilleiste (20, 21) angeordnet sind.

## Claims

1. Profile system for electrical/magnetic screening of a housing which has a opening which can be closed by a cover, having multi-piece profile strips (20,21,26,27) which can be connected to the edge region of the opening and of the cover and have sprung contacts (16,17,18), a contact web (19) of one profile strip (26,27) engaging in a U-shaped contact region of another profile strip (20,21), characterised in that the profile strips (20,21,26,27) are divided into inner (21,27) and outer strips (20,26) which can be installed separately and can be connected detachably to one another, the U-shaped contact region being formed by the interaction of an inner (21) and outer strip (20).

2. Profile system according to Claim 1, characterised in that the profile strip (20,21) is divided in the U-shaped contact region in the region of the contact web (19).

3. Profile system according to Claim 1 or 2, characterised in that the outer strip (20) forms an edge (23) on its outer side and a limb of the U-shaped compact region on its inner side, while the inner strip (21) forms the other limb of the U-shaped contact region.

4. Profile system according to Claim 3, characterised in that the inner strip (21) also forms the essential part of the web of the U-shaped contact region and is connected 22 via a connecting web 24, which is parallel to the edge, to the outer strip 20, preferably approximately in the centre of the edge.

5. Profile system according to Claim 4, characterised in that the end of the connecting web (24) which is parallel to the edge rests against a stop (25) which is constructed in the outer strip (20).

6. Profile system according to one of Claims 1 to 5, characterised in that the sprung contacts (16,17) are arranged on at least one limb of the U-shaped contact region.

7. Profile system according to one of Claims 1 to 6, characterised in that further contacts (18) are arranged in a U-shaped opposing groove of the profile strip (26,27), which is open in the closing direction, while the profile, especially the outer strip (20), is provided in the region of the opposing groove with a contact shoe (28) which is arranged in the closing direction.

8. Profile system according to Claim 7, characterised in that the web of the opposing groove is aligned with one side of the profile strip (26,27), while the one limb is formed by the edge 29 of the profile strip 26,27 and the other limb is formed by the contact web 19, the contacts 18 being arranged on the web.

9. Profile system according to one of Claims 1 to 8, characterised in that the profile strip (26,27) is provided with a sealing web (30) which is arranged essentially in the closing direction and engages in an elastic seal (31) which is arranged in the profile strip (20,21).

10. Profile system according to Claim 9, characterised in that the sealing web (30) is constructed on an extension (32) of the web of the opposing groove, while the limb of the U-shaped contact region which is formed by the inner strip (21) engages in the region between the contact piece (90) and the sealing web (30).

11. Profile system according to Claim 9 or 10, characterised in that the elastic seal (31) is arranged in a recess in the profile strip (20,21), while the outer side of the seal (31) is aligned with the side of the profile strip (20,21).

12. Profile system according to one of Claims 9 to 11, characterised in that the outer side of the sealing web 30 encloses an obtuse angle with the side of the profile strip (26,27).

13. Profile system according to one of Claims 1 to 12, characterised in that the profile strip (26,27) is screwed on via connecting webs (33,34) which are parallel to the edge, preferably connected approximately in the centre of the edge, the end of a connecting web (34) resting against a connection (35) which is constructed on another connecting web (33).

14. Profile system according to one of Claims 1 to 13, characterised in that the contact springs (16,17) are arranged in a recess in the profile strip (20,21).

## Revendications

1. Système de profilé, destiné au blindage électrique/magnétique d'un boîtier, présentant une ouverture obturable à l'aide d'un recouvrement, avec des bandes profilées (20,21,26,27) à plusieurs parties, susceptibles d'être reliées à la zone de bordure de l'ouverture et du recouvrement et disposant de contacts élastiques (16,17,18), où une nervure de contact (19) d'une bande profilée (20,21) vient s'engager dans une zone de contact en forme de U d'une autre bande profilé (20,21), caractérisé en ce que les bandes profilées (20,21,26,27) sont divisées en bandes intérieures (21,27) et en bandes extérieures (20,26), susceptibles d'être montées séparément, reliées ensemble de façon amovible, la zone de contact en forme de U étant formée par la coopération d'une bande intérieure (21) et d'une bande extérieure (20).

2. Système de profil selon la revendication 1, caractérisé en ce que, dans la zone de contact en forme de U, la bande profilée (20,21) est divisée dans la zone de la nervure de contact (19).

3. Système de profil selon la revendication 1 ou 2, caractérisé en ce que la bande extérieure (20) forme sur sa face extérieure une bordure (23) et sur sa face intérieure une branche de la zone de contact en forme de U, tandis que la face intérieure (21) forme l'autre branche de la zone de contact en forme de U.

4. Système de profil selon la revendication 3, caractérisé en ce que la bande intérieure (21) forme également la partie essentielle de la nervure de la zone de contact en forme de U et est reliée, par l'intermédiaire d'une nervure de liaison (24), à la bande extérieure (20), de préférence à peu près au centre de la bordure.

5. Système de profil selon la revendication 4, caractérisé en ce que l'extrémité de la nervure de liaison (24) parallèle à la bordure appuie sur une butée (25) réalisée dans la bande extérieure (20).

6. Système de profil selon l'une des revendications 1 à 5, caractérisé en ce que les contacts élastiques (16,17) sont disposés sur au moins une branche de la zone de contact en forme de U.

7. Système de profil selon l'une des revendications 1 à 6, caractérisé en ce que d'autres contacts (18) sont disposés dans une contre-moulure (26,27) en forme de U, ouverte dans le sens de la fermeture, de la bande profilée (26,27), tandis que le profilé, en particulier la bande extérieure (20) est pourvue dans la zone de la contre-moulure, d'un patin de contact (28) disposé dans le sens de la fermeture.

8. Système de profil selon la revendication 7, caractérisé en ce que la nervure de la contre-moulure est alignée par rapport à une face de la bande profilée (26,27), tandis que l'une des branches est formée par la bordure (29) de la bande profilée (26,27) et que l'autre branche est formée par la nervure de contact (19), les contacts (18) étant disposés sur la nervure.

9. Système de profil selon l'une des revendications 1 à 8, caractérisé en ce que la bande profilée (26,27) est pourvue d'une nervure d'étanchéité (30), disposée pratiquement dans le sens de la fermeture et s'engageant dans un joint d'étanchéité élastique (31) disposé dans la bande profilée (20,21).

10. Système de profil selon la revendication 9, caractérisé en ce que la nervure d'étanchéite (30) est réalisée sur un prolongement (32)de la nervure de la contre-moulure, tandis que la branche, formée par la bande intérieure (21), de la zone de contact en forme de U s'engage dans la zone située entre une pièce de contact (90) et la nervure d'étanchéité (30).

11. Système de profil selon la revendication 9 ou 10, caractérise en ce que le joint d'étanchéité élastique (31) est disposé dans un évidement de la bande profilée (20,21), tandis que la face extérieure du joint d'étanchéité (31) est alignée par rapport à la surface de la bande profilée (20,21).

12. Système de profil selon l'une des revendications 9 à 11, caractérisé en ce que la face extérieure de la nervure d'étanchéité (30) fait un angle obtus avec la surface de la bande profilée (26,27).

13. Système de profil selon l'une des revendications 1 à 12, caractérisé en ce que la bande profilée (26,27) est reliée, par l'intermédiaire de nervure de liaison (33,34) parallèles à la bordure, de préférence à peu près au centre de la bordure, la liaison s'effectuant par vissage, l'extrémité d'une nervure de liaison (34) appuyant sur un raccordement (35) réalisé sur l'autre nervure de liaison (33).

14. Système de profil selon l'une des revendications 1 à 13, caractérisé en ce que les ressorts de contact (16,17) sont disposés dans un renfoncement de la bande profilée (20,21).
